# EUROPEAN PATENT APPLICATION

(11) **EP 4 510 195 A1**
(43) Date of publication of application: **19.02.2025**
(21) Application number: 23787487.0
(22) Date of filing: 22.03.2023
(51) Int. Cl.: H01L 31/0216, H01L 31/0236, H01L 31/06, H01L 31/18

(54) **SOLAR CELL AND PRODUCTION METHOD THEREFOR, AND PHOTOVOLTAIC ASSEMBLY**

(30) Priority: 15.04.2022 CN 202210402288
(71) Applicant: Longi Green Energy Technology Co., Ltd., Xi'an, Shaanxi 710100 (CN)
(72) Inventor: WU, Zhao, Xi' an, Shaanxi 710100 (CN); XIE, Junjie, Xi' an, Shaanxi 710100 (CN); LIU, Tong, Xi' an, Shaanxi 710100 (CN); SUN, Zhuxing, Xi' an, Shaanxi 710100 (CN); DIAO, Yifan, Xi' an, Shaanxi 710100 (CN)
(74) Representative: Pfenning, Meinig & Partner mbB
(86) International application number: PCT/CN2023/083160
(87) International publication number: WO 2023/197840

(57) **Abstract**

This application provides a solar cell and a production method therefor, and a photovoltaic module, and relates to the field of photovoltaic technologies. The solar cell includes: a silicon substrate and a majority carrier tunneling field effect layer and a front selective contact layer stacked in sequence on a light receiving side of the silicon substrate. The front selective contact layer and the silicon substrate are of a same doping type. A density of fixed charges in the majority carrier tunneling field effect layer is greater than or equal to a preset density. A type of the fixed charges in the majority carrier tunneling field effect layer is the same as a charge type of minority carriers in the silicon substrate. A higher minority carrier energy gradient is established on the light receiving side of the silicon substrate to repel the minority carriers, so that non-equilibrium minority carriers in photogenerated non-equilibrium carriers of a light receiving surface of the silicon substrate can enter into the silicon substrate faster and more efficiently, and accordingly, a concentration of the non-equilibrium minority carriers in the photogenerated non-equilibrium carriers of the light receiving surface of the silicon substrate is reduced, thereby effectively reducing a recombination rate of the light receiving surface of the silicon substrate.

## Description

### CROSS-REFERENCE TO RELATED APPLICATIONS

This application claims priority to Chinese Patent Application No. 202210402288.X, filed with the China National Intellectual Property Administration on April 15, 2022 and entitled "SOLAR CELL, PRODUCTION METHOD THEREFOR, AND PHOTOVOLTAIC MODULE HAVING SAME", which is incorporated herein by reference in its entirety.

### TECHNICAL FIELD

This application relates to the field of photovoltaic technologies, and in particular, to a solar cell, a production method therefor, and a photovoltaic module having same.

### BACKGROUND

A solar cell is a power generation manner in which light energy is directly converted into electrical energy for output, and has broad application prospects as a clean energy source.

Currently, all solar cells have a problem of poor short-wave response. The poor short-wave response leads to reduced photoelectric conversion efficiency of the solar cells.

### SUMMARY

This application provides a solar cell and a production method therefor, and a photovoltaic module, to resolve a problem that a solar cell has poor short-wave response.

According to a first aspect of this application, a solar cell is provided, including:
a silicon substrate, and a majority carrier tunneling field effect layer and a front selective contact layer stacked in sequence on a light receiving side of the silicon substrate, where the front selective contact layer and the silicon substrate are of a same doping type; and
a density of fixed charges in the majority carrier tunneling field effect layer is greater than or equal to a preset density, and a type of the fixed charges in the majority carrier tunneling field effect layer is the same as a charge type of minority carriers in the silicon substrate.

In embodiments of this application, the majority carrier tunneling field effect layer is located between the silicon substrate and the front selective contact layer, and the density of the fixed charges in the majority carrier tunneling field effect layer is greater than the preset density. A higher minority carrier energy gradient is established on the light receiving side of the silicon substrate to repel the minority carriers, so that non-equilibrium minority carriers in photogenerated non-equilibrium carriers of a light receiving surface of the silicon substrate can enter into the silicon substrate faster and more efficiently, to be collected and exported fast, and accordingly, a concentration of the non-equilibrium minority carriers in the photogenerated non-equilibrium carriers of the light receiving surface of the silicon substrate is reduced, thereby effectively reducing a recombination rate of the light receiving surface of the silicon substrate, which can improve photoelectric conversion efficiency of the solar cell.

Optionally, the preset density is greater than or equal to 10¹⁰/cm².

Optionally, the preset density is greater than or equal to 10¹¹/cm².

Optionally, a material of the majority carrier tunneling field effect layer is selected from a dielectric material with a dielectric constant greater than or equal to 8.

Optionally, pinholes are provided in the majority carrier tunneling field effect layer, and the pinholes are filled with a material corresponding to the front selective contact layer.

Optionally, an average pore diameter of the pinholes is less than or equal to 100 nm, and a density of the pinholes is less than or equal to 10⁹/cm².

Optionally, the dielectric material includes a transition metal oxide.

Optionally, in a case that the silicon substrate is a P-type silicon substrate, the dielectric material includes at least one of tantalum oxide, titanium oxide, strontium titanium oxide, or zirconium oxide; and
in a case that the silicon substrate is an N-type silicon substrate, the dielectric material includes at least one of hafnium oxide, hafnium silicon oxide, yttrium oxide, or a lanthanide metal oxide.

Optionally, the material of the majority carrier tunneling field effect layer further includes hydrogen.

Optionally, the silicon substrate and the majority carrier tunneling field effect layer are arranged immediately adjacent to each other; or
the solar cell further includes a chemical passivation interface layer located between the silicon substrate and the majority carrier tunneling field effect layer, a thickness of the chemical passivation interface layer is less than or equal to 1 nm, and a direction of the thickness of the chemical passivation interface layer is perpendicular to a light receiving surface of the silicon substrate.

Optionally, the chemical passivation interface layer is located on a surface of the silicon substrate, the chemical passivation interface layer is a silicon-oxygen bond layer, and the thickness of the chemical passivation interface layer is less than or equal to 0.5 nm.

Optionally, the majority carrier tunneling field effect layer is a single-layer structure or a multi-layer structure; and/or
a thickness of the majority carrier tunneling field effect layer is in a range of 0.5 to 5 nm, and a direction of the thickness of the majority carrier tunneling field effect layer is perpendicular to a light receiving surface of the silicon substrate.

Optionally, the thickness of the majority carrier tunneling field effect layer is in a range of 0.5 to 2 nm.

Optionally, an area of a projection of the front selective contact layer on a light receiving surface of the silicon substrate is less than or equal to an area of the light receiving surface of the silicon substrate; and/or
an area of a projection of the majority carrier tunneling field effect layer on the light receiving surface of the silicon substrate is less than or equal to the area of the light receiving surface of the silicon substrate.

Optionally, an area of a projection of the majority carrier tunneling field effect layer on a light receiving surface of the silicon substrate is greater than or equal to an area of a projection of the front selective contact layer on the light receiving surface of the silicon substrate; and the projection of the front selective contact layer on the light receiving surface of the silicon substrate entirely falls within the projection of the majority carrier tunneling field effect layer on the light receiving surface of the silicon substrate.

Optionally, the front selective contact layer is a single-layer structure or a multi-layer structure; and/or
a bandgap of a material of the front selective contact layer is greater than or equal to a preset bandgap; and/or
a doping concentration of the silicon substrate is negatively correlated with a thickness of the silicon substrate, and a direction of the thickness of the silicon substrate is perpendicular to a light receiving surface of the silicon substrate; and/or
the solar cell is one of a heterojunction solar cell, a polysilicon passivated contact solar cell, or a wide-bandgap passivated contact solar cell; and/or
the silicon substrate has a front junction structure or a back junction structure.

Optionally, a material of the front selective contact layer is selected from at least one of doped amorphous silicon, doped polysilicon, aluminum-doped zinc oxide, indium tin oxide, zinc oxide, tin oxide, nickel oxide, titanium nitride, or molybdenum oxide.

According to a second aspect of this application, a photovoltaic module is provided, including a plurality of solar cells each being the solar cell according to any one of the foregoing.

According to a third aspect of this application, a production method for the solar cell according to any one of the foregoing is provided, including:
stacking a majority carrier tunneling field effect layer and a front selective contact layer in sequence on a light receiving side of a silicon substrate, where the front selective contact layer and the silicon substrate are of a same doping type; and a density of fixed charges in the majority carrier tunneling field effect layer is greater than or equal to a preset density, and a type of the fixed charges in the majority carrier tunneling field effect layer is the same as a charge type of minority carriers in the silicon substrate.

Optionally, a material of the majority carrier tunneling field effect layer is selected from a dielectric material, and the method further includes:
performing injection on the majority carrier tunneling field effect layer, to cause a charge type on a surface of the majority carrier tunneling field effect layer close to the silicon substrate after the injection to be the same as the type of the fixed charges.

Optionally, the injection includes at least one of electrical injection, optical injection, or hot injection.

Optionally, a voltage of the electrical injection is less than a breakdown voltage of the solar cell;
the optical injection is performed through irradiation with ultraviolet light, where a wavelength of the ultraviolet light is less than or equal to 300 nm; and
a temperature of the hot injection is greater than or equal to 600°C.

Optionally, the majority carrier tunneling field effect layer is arranged through a deposition process.

The foregoing descriptions are merely an overview of the technical solutions of this application. To understand the technical means of this application more clearly, implementation can be performed according to content of the specification. Moreover, to make the foregoing and other objectives, features, and advantages of this application more comprehensible, specific implementations of this application are particularly described below.

### BRIEF DESCRIPTION OF THE DRAWINGS

To describe the technical solutions in the embodiments of this application or the related art more clearly, accompanying drawings required for describing the embodiments or the related art are briefly described below. Apparently, the accompanying drawings in the following descriptions show some embodiments of this application, and a person of ordinary skill in the art may still derive other drawings from the accompanying drawings without creative efforts.
FIG. 1 is a schematic structural diagram of a first type of solar cell according to an embodiment of this application;
FIG. 2 is a schematic structural diagram of a non-equilibrium energy band on a light receiving surface of an N-type silicon substrate in a working state according to an embodiment of this application;
FIG. 3 is a schematic structural diagram of a second type of solar cell according to an embodiment of this application;
FIG. 4 is a schematic structural diagram of a third type of solar cell according to an embodiment of this application;
FIG. 5 is a schematic structural diagram of a fourth type of solar cell according to an embodiment of this application;
FIG. 6 is a flowchart of steps of a production method for a solar cell according to an embodiment of this application;
FIG. 7 is a schematic structural diagram of a fifth type of solar cell according to an embodiment of this application;
FIG. 8 is a schematic structural diagram of a sixth type of solar cell according to an embodiment of this application; and
FIG. 9 is a schematic structural diagram of a seventh type of solar cell according to an embodiment of this application.

### DESCRIPTION OF REFERENCE SIGNS:

1-silicon substrate, 2-majority carrier tunneling field effect layer, 310-front passivation layer, 311-front selective contact layer, 312-front anti-reflection layer, 32-front electrode, 41-back functional layer, 410-back passivation layer, 411-back selective contact layer, 412-back anti-reflection layer, and 42-back electrode.

### DETAILED DESCRIPTION

To make the objectives, technical solutions, and advantages of embodiments of this application clearer, the following clearly and completely describes the technical solutions in the embodiments of this application with reference to the accompanying drawings in the embodiments of this application. Apparently, the described embodiments are some of the embodiments of this application rather than all the embodiments. All other embodiments obtained by a person of ordinary skill in the art based on the embodiments of this application without creative efforts shall fall within the protection scope of this application.

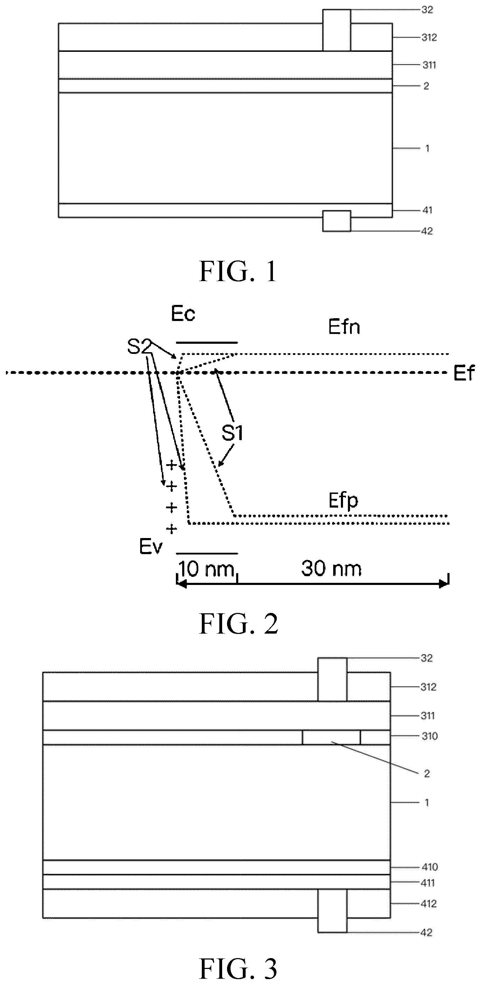

FIG. 1 is a schematic structural diagram of a first type of solar cell according to an embodiment of this application. Referring to FIG. 1, an embodiment of this application provides a solar cell, including: a silicon substrate 1 and a majority carrier tunneling field effect layer 2 and a front selective contact layer 311 stacked in sequence on a light receiving side of the silicon substrate 1. The majority carrier tunneling field effect layer 2 and a light receiving surface of the silicon substrate 1 are arranged immediately adjacent to each other, or there may be another substance between the majority carrier tunneling field effect layer 2 and the light receiving surface of the silicon substrate 1, which is not specifically limited in this embodiment of this application.

The front selective contact layer 311 and the silicon substrate 1 are of a same doping type. For example, if a doping type of the silicon substrate 1 is an N type, a doping type of the front selective contact layer 311 is also the N type, and if the doping type of the silicon substrate 1 is a P type, the doping type of the front selective contact layer 311 is also the P type. The front selective contact layer 311 is configured to separate and transport majority carriers. A charge type of the majority carriers is the same as that of majority carriers in the silicon substrate. Transmission of majority carriers in the solar cell does not have a limited direction, and may be horizontal transmission, vertical transmission, transmission in any direction, or the like. It should be noted that a charge type of majority carriers mentioned throughout the specification is the same as a charge type of majority carriers in the silicon substrate 1, and a charge type of minority carriers mentioned throughout the specification is the same as a charge type of minority carriers in the silicon substrate 1. The light receiving surface of the silicon substrate 1 mentioned throughout the specification is a surface of the silicon substrate 1 that receives light. A back surface of the silicon substrate 1 mentioned throughout the specification is arranged opposite to the light receiving surface of the silicon substrate 1.

The majority carrier tunneling field effect layer 2 can allow carriers of a charge type the same as that the majority carriers in the silicon substrate to tunnel through the layer, thereby not affecting collection of the majority carriers while not increasing contact resistance on the light receiving side of the silicon substrate 1.

A density of fixed charges in the majority carrier tunneling field effect layer 2 is greater than or equal to a preset density. A type of the fixed charges in the majority carrier tunneling field effect layer 2 is the same as a charge type of minority carriers in the silicon substrate 1. To be specific, if the silicon substrate 1 is an N-type silicon substrate, and minority carriers in the N-type silicon substrate are holes, a density of positive fixed charges in the majority carrier tunneling field effect layer 2 is greater than or equal to the preset density. If the silicon substrate 1 is a P-type silicon substrate, and minority carriers in the P-type silicon substrate are electrons, a density of negative fixed charges in the majority carrier tunneling field effect layer 2 is greater than or equal to the preset density.

Specifically, it is found by the inventor that in the related art, a reason why a solar cell has poor short-wave response is that: The light receiving surface of the silicon substrate 1 has a high short-wave absorption coefficient, resulting in a very high concentration of non-equilibrium carriers of the light receiving surface of the silicon substrate 1 under irradiation. The high-concentration non-equilibrium carriers cannot be exported and collected in time and effectively, resulting in severe recombination of the light receiving surface of the silicon substrate 1.

By exploring the reason, the inventor finds that separation and export of carriers mainly rely on a concentration gradient (a diffusion current) of the carriers and an energy gradient (a drift current) of the carriers. Since the light receiving surface of the silicon substrate 1 is close to the front selective contact layer 311, it is difficult to form a large carrier concentration gradient in this region. Therefore, the front selective contact layer 311 mainly relies on the energy gradient to separate and export carriers, absorb majority carriers, and repel minority carriers. In a case that the front selective contact layer 311 has weak selectivity, the front selective contact layer 311 has a weak capability of separating majority carriers and minority carriers. Consequently, non-equilibrium carriers generated by the light receiving surface of the silicon substrate 1 cannot be effectively separated and exported, and particularly, non-equilibrium minority carriers cannot be effectively separated and exported, resulting in a high recombination rate of the light receiving surface of the silicon substrate 1.

Therefore, in this embodiment of this application, the majority carrier tunneling field effect layer 2 is located between the silicon substrate 1 and the front selective contact layer 311, and the density of the fixed charges in the majority carrier tunneling field effect layer 2 is greater than the preset density. In addition, the type of the fixed charges in the majority carrier tunneling field effect layer 2 is the same as the charge type of the minority carriers in the silicon substrate 1. A higher minority carrier energy gradient is established on the light receiving side of the silicon substrate 1 to repel the minority carriers, so that non-equilibrium minority carriers in photogenerated non-equilibrium carriers of a light receiving surface of the silicon substrate 1 can enter into the silicon substrate 1 faster and more efficiently, to be collected and exported fast, and accordingly, a concentration of the non-equilibrium minority carriers in the photogenerated non-equilibrium carriers of the light receiving surface of the silicon substrate 1 is reduced, thereby effectively reducing a recombination rate of the light receiving surface of the silicon substrate 1, which can improve photoelectric conversion efficiency of the solar cell.

FIG. 2 is a schematic structural diagram of a non-equilibrium energy band on a light receiving surface of an N-type silicon substrate in a working state according to an embodiment of this application. More specifically, the inventive concept of this application is further explained below with reference to FIG. 2:
Referring to FIG. 2, in a case that the silicon substrate 1 is an N-type silicon substrate, Ef is a Fermi level on a light receiving surface of the N-type silicon substrate in a thermal equilibrium state (in a non-working state), Efn is a quasi-Fermi level of electrons of the light receiving surface of the N-type silicon substrate in a working state, Efp is a quasi-Fermi level of holes of the light receiving surface of the N-type silicon substrate in the working state, Ec and Ev respectively represent a conduction band edge and a valance band edge of the light receiving surface of the N-type silicon substrate, a lower double-headed arrow scale represents a depth distance from the light receiving surface of the N-type silicon substrate to a back surface thereof, S1 represents continuous quasi-Fermi levels of the light receiving surface of the N-type silicon substrate in the working state when selectivity is weak, and S2 represents continuous quasi-Fermi levels of the light receiving surface of the N-type silicon substrate in the working state after the selectivity is enhanced.

In a path corresponding to S1, positions corresponding to Efn and Efp may represent concentrations of non-equilibrium carriers. Photogenerated holes generated in a region of the light receiving surface of the N-type silicon substrate in the solar cell cannot be transferred to a bulk on a right side in time, resulting in recombination of the photogenerated holes and electrons at a surface layer and reduced slopes of Efn and Efp (which are represented by straight lines for simplification of the figure, and are actually continuous curves) in the path of S1. Consequently, a concentration of minority carriers in the region in the figure decreases, and an open circuit voltage of the solar cell decreases. Surface recombination in the path of S1 reduces a yield of short-wave photogenerated carriers at a surface layer of the solar cell, resulting in reduced short-wave response.

In this embodiment of this application, a majority carrier tunneling field effect layer with a high density of positive fixed charges is arranged on the light receiving surface of the N-type silicon substrate in the solar cell. The positive fixed charges generate an electric field repelling the photogenerated holes, so that the photogenerated holes can escape from the light receiving surface of the N-type silicon substrate faster to enter the bulk, thereby reducing surface recombination and implementing a path of S2, so that the short-wave response and the open circuit voltage of the solar cell are improved.

Optionally, a preset density is greater than or equal to 10¹⁰/cm² (a quantity of fixed charges per square centimeter). To be specific, if a type of fixed charges in the majority carrier tunneling field effect layer 2 is the same as a charge type of minority carriers in the silicon substrate 1, and a density of the fixed charges in the majority carrier tunneling field effect layer 2 is greater than or equal to 10¹⁰/cm², an electric field generated by the fixed charges in the majority carrier tunneling field effect layer 2 and repelling non-equilibrium minority carriers is stronger, and an effect of repelling the non-equilibrium minority carriers of the light receiving surface of the silicon substrate is stronger, so that the non-equilibrium minority carriers can escape from the light receiving surface of the silicon substrate faster to enter the bulk, thereby reducing surface recombination, and further improving the short-wave response and the open circuit voltage of the solar cell.

It should be noted that a reason why as long as the preset charge density is greater than or equal to 10¹⁰/cm², the electric field generated by the fixed charges in the majority carrier tunneling field effect layer 2 and repelling the non-equilibrium minority carriers is very strong, and the effect of repelling the non-equilibrium minority carriers of the light receiving surface of the silicon substrate is stronger, so that the non-equilibrium minority carriers can escape from the light receiving surface of the silicon substrate faster to enter the bulk, thereby reducing surface recombination, lies in that: During normal working of the majority carrier tunneling field effect layer 2 in the solar cell, there is a voltage difference between an end of the majority carrier tunneling field effect layer 2 close to the silicon substrate 1 and an end of the majority carrier tunneling field effect layer 2 away from the silicon substrate 1. The voltage difference enables the majority carrier tunneling field effect layer 2 to be polarized, and a polarization direction is the same as a direction of the electric field repelling non-equilibrium carriers. Therefore, the polarized charges can also repel non-equilibrium carriers, so that the non-equilibrium minority carriers can escape from the light receiving surface of the silicon substrate faster to enter the bulk, thereby reducing surface recombination. That is, the fixed charges in the majority carrier tunneling field effect layer 2 and the polarization caused by the voltage difference between the two ends of the majority carrier tunneling field effect layer 2 during normal working function together to reduce surface recombination. Therefore, as long as the preset charge density is greater than or equal to 10¹⁰/cm², a good effect can be achieved. Certainly, a larger preset charge density may be better for the effect of reducing surface recombination.

Preferably, the preset density is greater than or equal to 10¹¹/cm². To be specific, if a type of fixed charges in the majority carrier tunneling field effect layer 2 is the same as a charge type of minority carriers in the silicon substrate 1, and a density of the fixed charges in the majority carrier tunneling field effect layer 2 is greater than or equal to 10¹¹/cm², an electric field generated by the fixed charges in the majority carrier tunneling field effect layer 2 and repelling non-equilibrium minority carriers is further enhanced, and an effect of repelling the non-equilibrium minority carriers of the light receiving surface of the silicon substrate is further enhanced, so that the non-equilibrium minority carriers can escape from the light receiving surface of the silicon substrate faster to enter the bulk, thereby reducing surface recombination, and further improving the short-wave response and the open circuit voltage of the solar cell.

It should be noted that when either the density of the fixed charges in the majority carrier tunneling field effect layer 2 is less than the preset charge density, or when the density of the fixed charges in the majority carrier tunneling field effect layer 2 reaches the preset charge density, the density of the fixed charges can be increased by injection. Specifically, some of the fixed charges in the majority carrier tunneling field effect layer 2 originate from electrons or holes in the silicon substrate 1, and are bound by defects in the majority carrier tunneling field effect layer 2, thereby being fixed into the majority carrier tunneling field effect layer 2 and implements a field effect. Through optical injection, hot injection, or application of an external electric field, that is, electrical injection, charges in the silicon substrate 1 can be promoted to migrate, to improve a probability that the charges enter the majority carrier tunneling field effect layer 2 and are bound and fixed, thereby increasing the density of the fixed charges.

Optionally, a material of the majority carrier tunneling field effect layer 2 is selected from a dielectric material with a dielectric constant greater than or equal to 8. Specifically, the dielectric is an insulator that can be polarized. Before being polarized, charged particles in the dielectric are closely bound by internal forces of atoms or molecules, or intermolecular forces, and therefore, charges of the particles are bound charges. Under the action of an external electric field, the charges move within a microscopic range, to be polarized. In a case that the material of the majority carrier tunneling field effect layer 2 is selected from a dielectric material with a dielectric constant greater than or equal to 8, after the polarized charges move within the microscopic range, charges with a charge type the same as the charge type of the minority carriers in the silicon substrate 1 move to a surface of the majority carrier tunneling field effect layer 2 close to the silicon substrate 1, and further, the charges with a charge type the same as the charge type of the minority carriers in the silicon substrate 1 are greatly increased on the surface of the majority carrier tunneling field effect layer 2 close to the silicon substrate 1. An electric field generated by the fixed charges in the majority carrier tunneling field effect layer 2 and repelling non-equilibrium minority carriers is further enhanced, and an effect of repelling the non-equilibrium minority carriers of the light receiving surface of the silicon substrate 1 is further enhanced, so that the non-equilibrium minority carriers can escape from the light receiving surface of the silicon substrate 1 faster to enter the bulk, thereby reducing surface recombination, and further improving the short-wave response and the open circuit voltage of the solar cell. In addition, the dielectric constant is used to represent a relative capability of storing electrostatic energy in an electric field by a dielectric. A larger dielectric constant indicates easier polarization or more polarized charges generated under the same external field condition. After microscopic movement, on the surface of the majority carrier tunneling field effect layer 2 close to the silicon substrate 1, the density of the charges with a charge type the same as the charge type of the minority carriers in the silicon substrate 1 is larger, which is more conducive to enhancing the effect of repelling the non-equilibrium minority carriers of the light receiving surface of the silicon substrate 1, so that the non-equilibrium minority carriers can escape from the light receiving surface of the silicon substrate 1 faster to enter the bulk, thereby reducing surface recombination, and further improving the short-wave response and the open circuit voltage of the solar cell. In addition, the majority carrier tunneling field effect layer 2 includes a dielectric material with a dielectric constant greater than or equal to 8. During normal working of the majority carrier tunneling field effect layer 2 in the solar cell, there is a larger voltage difference between an end of the majority carrier tunneling field effect layer 2 close to the silicon substrate 1 and an end of the majority carrier tunneling field effect layer 2 away from the silicon substrate 1. The voltage difference enables the majority carrier tunneling field effect layer 2 to be polarized to a greater extent, and a polarization direction is the same as a direction of the electric field repelling non-equilibrium carriers. Therefore, the larger quantity of polarized charges can also repel non-equilibrium carriers better, so that the non-equilibrium minority carriers can escape from the light receiving surface of the silicon substrate faster to enter the bulk, thereby reducing surface recombination.

Optionally, pinholes are provided in the majority carrier tunneling field effect layer 2, and the pinholes are filled with a material corresponding to the front selective contact layer 311, which can enhance conductivity of the majority carrier tunneling field effect layer 2 and is conducive to improving electrical performance of the solar cell.

Optionally, an average pore diameter of the pinholes is less than or equal to 100 nm, and a density of the pinholes is less than or equal to 10⁹/cm². Specifically, the pinholes are filled with the material corresponding to the front selective contact layer 311, which can enhance conductivity of the majority carrier tunneling field effect layer 2 and is conducive to improving electrical performance of the solar cell. However, the material corresponding to the front selective contact layer 311 filled in the pinholes also weakens passivation and field-effect performance. In a case that the average pore diameter of the pinholes is less than or equal to 100 nm, and the density of the pinholes is less than or equal to 10⁹/cm², a good equilibrium is achieved between improving the electrical performance of the solar cell and improving the passivation and field-effect performance.

Preferably, the average pore diameter of the pinholes is less than or equal to 50 nm, and the density of the pinholes is less than or equal to 10⁷/cm². In this case, a good equilibrium is achieved between improving the electrical performance of the solar cell and improving the passivation and field-effect performance.

It should be noted that the majority carrier tunneling field effect layer may also be doped with a doping element the same as that of the front selective contact layer 311, which is conducive to improving the electrical performance of the solar cell. In this application, whether the majority carrier tunneling field effect layer is doped with the doping element the same as that of the front selective contact layer 311 is not specifically limited.

Optionally, the dielectric material with a dielectric constant greater than or equal to 8 may include a transition metal oxide. In this case, oxygen in the transition metal oxide may be combined with a silicon dangling bond of a surface of the silicon substrate 1 to form a silicon-oxygen bond layer, which implements good chemical passivation.

Optionally, in a case that the silicon substrate 1 is a P-type silicon substrate, the dielectric material includes at least one of tantalum oxide, titanium oxide, strontium titanium oxide, or zirconium oxide. After the dielectric material of the foregoing material is polarized, on a surface of the majority carrier tunneling field effect layer 2 close to the silicon substrate 1, the density of the charges with a charge type the same as the charge type of the minority carriers in the silicon substrate 1 is larger, which is more conducive to enhancing the effect of repelling the non-equilibrium minority carriers of the light receiving surface of the silicon substrate 1.

Specifically, tantalum oxide (TazOs) has a dielectric constant of 22, and after the tantalum oxide is polarized, a density of negative charges on the surface of the majority carrier tunneling field effect layer 2 close to the silicon substrate 1 is large. Titanium oxide (TiO₂) has a dielectric constant of 80, and after the titanium oxide is polarized, a density of negative charges on the surface of the majority carrier tunneling field effect layer 2 close to the silicon substrate 1 is large. Strontium titanium oxide (SrTiO₃) has a dielectric constant of 2000, and after the strontium titanium oxide is polarized, a density of negative charges on the surface of the majority carrier tunneling field effect layer 2 close to the silicon substrate 1 is large. Zirconium oxide (ZrO₂) has a dielectric constant of 25, and after the zirconium oxide is polarized, a density of negative charges on the surface of the majority carrier tunneling field effect layer 2 close to the silicon substrate 1 is large. For example, the dielectric material may be selected from a Ta₂O₅/TiO₂ stack.

Optionally, in a case that the silicon substrate 1 is an N-type silicon substrate, the dielectric material includes at least one of hafnium oxide, hafnium silicon oxide, yttrium oxide, or a lanthanide metal oxide. After the dielectric material of the foregoing material is polarized, on a surface of the majority carrier tunneling field effect layer 2 close to the silicon substrate 1, the density of the charges with a charge type the same as the charge type of the minority carriers in the silicon substrate 1 is larger, which is more conducive to enhancing the effect of repelling the non-equilibrium minority carriers of the light receiving surface of the silicon substrate 1.

Specifically, hafnium oxide (HfO₂) has a dielectric constant of 25, and after the hafnium oxide is polarized, a density of positive charges on the surface of the majority carrier tunneling field effect layer 2 close to the silicon substrate 1 is large. Hafnium silicon oxide (HfSiO₄) has a dielectric constant of 11, and after the hafnium silicon oxide is polarized, a density of positive charges on the surface of the majority carrier tunneling field effect layer 2 close to the silicon substrate 1 is large. Yttrium oxide (Y₂O₃) has a dielectric constant of 15, and after the yttrium oxide is polarized, a density of negative charges on the surface of the majority carrier tunneling field effect layer 2 close to the silicon substrate 1 is large. A lanthanide metal oxide has a dielectric constant of about 30, and after the lanthanide metal oxide is polarized, a density of positive charges on the surface of the majority carrier tunneling field effect layer 2 close to the silicon substrate 1 is large. The lanthanide metal oxide may be lanthanum oxide or the like. For example, the dielectric material may be selected from lanthanum aluminum oxide (LaAlO₃).

Optionally, the material of the majority carrier tunneling field effect layer 2 may further include hydrogen. A content and a source of the hydrogen in the majority carrier tunneling field effect layer 2 are not specifically limited. The hydrogen in the majority carrier tunneling field effect layer 2 is combined with a silicon dangling bond, which can improve the passivation performance of the solar cell.

Optionally, referring to FIG. 1, the silicon substrate 1 and the majority carrier tunneling field effect layer 2 are arranged immediately adjacent to each other. The majority carrier tunneling field effect layer 2 also has a specific chemical passivation effect. A distance between the majority carrier tunneling field effect layer 2 and the silicon substrate 1 is smaller, which further enhances the effect of repelling the non-equilibrium minority carriers of the light receiving surface of the silicon substrate 1. Alternatively, the solar cell further includes a chemical passivation interface layer located between the silicon substrate 1 and the majority carrier tunneling field effect layer 2. A thickness of the chemical passivation interface layer is less than or equal to 1 nm. A direction of the thickness of the chemical passivation interface layer is perpendicular to the light receiving surface of the silicon substrate 1. The thickness of the chemical passivation interface layer is small, and a distance between the majority carrier tunneling field effect layer 2 and the silicon substrate 1 is also small, which further enhances the effect of repelling the non-equilibrium minority carriers of the light receiving surface of the silicon substrate 1. For example, the chemical passivation interface layer may be made of silicon oxide or intrinsic amorphous silicon.

Optionally, the chemical passivation interface layer is located on a surface of the silicon substrate 1. The chemical passivation interface layer is a silicon-oxygen bond layer. The silicon-oxygen bond layer may be formed by combining oxygen in the majority carrier tunneling field effect layer 2 and a silicon dangling bond in the silicon substrate 1. The thickness of the chemical passivation interface layer is less than or equal to 0.5 nm. A distance between the majority carrier tunneling field effect layer 2 and the silicon substrate 1 is smaller, which further enhances the effect of repelling the non-equilibrium minority carriers of the light receiving surface of the silicon substrate 1.

Optionally, the majority carrier tunneling field effect layer 2 is a single-layer structure or a multi-layer structure. The majority carrier tunneling field effect layer 2 is in various forms. For example, the majority carrier tunneling field effect layer 2 may be made of a Ta₂O₅/TiO₂ stack.

Optionally, a thickness of the majority carrier tunneling field effect layer 2 is in a range of 0.5 to 5 nm, and a direction of the thickness of the majority carrier tunneling field effect layer 2 is perpendicular to the light receiving surface of the silicon substrate 1. If the thickness of the majority carrier tunneling field effect layer 2 falls within the range, the effect of repelling the non-equilibrium minority carriers of the light receiving surface of the silicon substrate 1 is strong.

Preferably, the thickness of the majority carrier tunneling field effect layer 2 is in a range of 0.5 to 2 nm. The thickness of the majority carrier tunneling field effect layer 2 is small, and the effect of repelling the non-equilibrium minority carriers of the light receiving surface of the silicon substrate 1 is stronger.

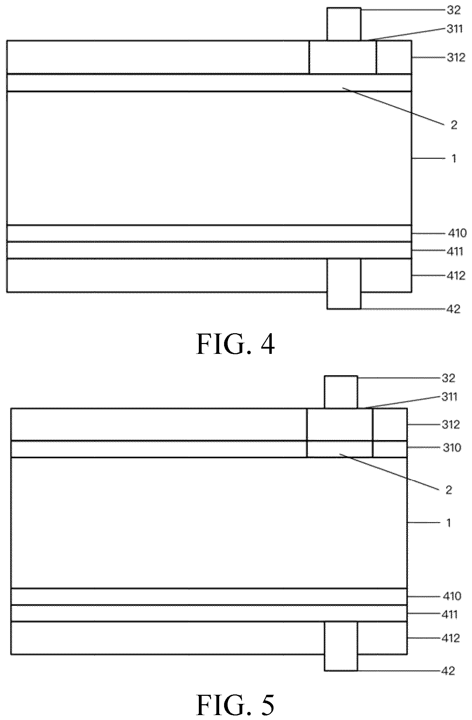

FIG. 3 is a schematic structural diagram of a second type of solar cell according to an embodiment of this application. FIG. 4 is a schematic structural diagram of a third type of solar cell according to an embodiment of this application. FIG. 5 is a schematic structural diagram of a fourth type of solar cell according to an embodiment of this application. Referring to FIG. 1, FIG. 3, FIG. 4, and FIG. 5, optionally, an area of a projection of the front selective contact layer 311 on a light receiving surface of the silicon substrate 1 is less than or equal to an area of the light receiving surface of the silicon substrate 1, which is conducive to separation and collection of majority carriers in the silicon substrate 1. As shown in FIG. 1, the area of the projection of the front selective contact layer 311 on the light receiving surface of the silicon substrate 1 is equal to the area of the light receiving surface of the silicon substrate 1.

Referring to FIG. 1, FIG. 3, FIG. 4, and FIG. 5, optionally, an area of a projection of the majority carrier tunneling field effect layer 2 on the light receiving surface of the silicon substrate 1 is less than or equal to the area of the light receiving surface of the silicon substrate 1. The majority carrier tunneling field effect layer 2 is arranged in various forms. As shown in FIG. 1, the area of the projection of the majority carrier tunneling field effect layer 2 on the light receiving surface of the silicon substrate 1 is equal to the area of the light receiving surface of the silicon substrate 1.

Referring to FIG. 1, FIG. 4, and FIG. 5, optionally, an area of a projection of the majority carrier tunneling field effect layer 2 on a light receiving surface of the silicon substrate 1 is greater than or equal to an area of a projection of the front selective contact layer 311 on the light receiving surface of the silicon substrate 1; and the projection of the front selective contact layer 311 on the light receiving surface of the silicon substrate 1 entirely falls within the projection of the majority carrier tunneling field effect layer 2 on the light receiving surface of the silicon substrate 1. Specifically, an effect of the majority carrier tunneling field effect layer 2 is to enhance selectivity of the front selective contact layer 311 for majority carriers. A positional relationship between the majority carrier tunneling field effect layer 2 and the front selective contact layer 311 is described above. The majority carrier tunneling field effect layer 2 has a better effect of enhancing the selectivity of the front selective contact layer 311 for the majority carriers.

Optionally, in a case that the area of the projection of the majority carrier tunneling field effect layer 2 on the light receiving surface of the silicon substrate 1 is less than the area of the light receiving surface of the silicon substrate 1, and/or in a case that the area of the projection of the front selective contact layer 311 on the light receiving surface of the silicon substrate 1 is less than the area of the light receiving surface of the silicon substrate 1, if the silicon substrate 1 is a P-type silicon substrate, the material of the majority carrier tunneling field effect layer 2 may also be selected from aluminum oxide, and a density of negative charges on a surface of the majority carrier tunneling field effect layer 2 close to the silicon substrate 1 is large.

It should be noted that in the solar cell shown in FIG. 3, the area of the projection of the majority carrier tunneling field effect layer 2 on the light receiving surface of the silicon substrate 1 is less than the area of the projection of the front selective contact layer 311 on the light receiving surface of the silicon substrate 1. Therefore, in the solar cell shown in FIG. 3, there is still carrier transmission in a horizontal direction. In FIG. 4, the area of the projection of the majority carrier tunneling field effect layer 2 on the light receiving surface of the silicon substrate 1 is greater than the area of the projection of the front selective contact layer 311 on the light receiving surface of the silicon substrate 1. In this way, an optical loss caused by parasitic absorption of free carriers in the front selective contact layer 311 can be significantly reduced, and the photoelectric conversion efficiency of the solar cell can be further improved. In FIG. 5, the area of the projection of the majority carrier tunneling field effect layer 2 on the light receiving surface of the silicon substrate 1 is equal to the area of the projection of the front selective contact layer 311 on the light receiving surface of the silicon substrate 1. In this way, the optical loss caused by parasitic absorption of free carriers in the front selective contact layer 311 can also be significantly reduced, and the photoelectric conversion efficiency of the solar cell can be further improved.

In FIG. 3, the majority carrier tunneling field effect layer 2 is located in a front passivation layer 310, and the area of the projection of the front selective contact layer 311 on the light receiving surface of the silicon substrate 1 is equal to the area of the light receiving surface of the silicon substrate 1. In FIG. 4, the front selective contact layer 311 is located in a front anti-reflection layer 312, and the area of the projection of the majority carrier tunneling field effect layer 2 on the light receiving surface of the silicon substrate 1 is equal to the area of the light receiving surface of the silicon substrate 1. In FIG. 5, the majority carrier tunneling field effect layer 2 is located in the front passivation layer 310, and the front selective contact layer 311 is located in the front anti-reflection layer 312.

Optionally, the front selective contact layer 311 is a single-layer structure or a multi-layer structure, and the front selective contact layer 311 is in various forms.

Optionally, a bandgap of a material of the front selective contact layer 311 is greater than or equal to a preset bandgap, leading to stronger selectivity for majority carriers, which is conducive to improving the photoelectric conversion efficiency of the solar cell. The preset bandgap may be selected according to actual needs, and is not specifically limited in this embodiment of this application.

Optionally, a doping concentration of the silicon substrate 1 is negatively correlated with a thickness of the silicon substrate 1, so that a bulk resistance of the silicon substrate 1 can be maintained. A direction of the thickness of the silicon substrate 1 is perpendicular to the light receiving surface of the silicon substrate 1.

Optionally, the solar cell may be one of a heterojunction solar cell, a polysilicon passivated contact solar cell, or a wide-bandgap passivated contact solar cell. In all the types of solar cells described above, the majority carrier tunneling field effect layer can enhance the effect of repelling the non-equilibrium minority carriers of the light receiving surface of the silicon substrate 1.

Optionally, the silicon substrate 1 has a front junction structure or a back junction structure, and the solar cell is in various forms. For example, when the silicon substrate 1 includes a doping structure, the silicon substrate 1 may be of a front junction structure or a back junction structure. To weaken lattice defects caused by front doping and Auger recombination caused by a high doping concentration, the back junction structure may be selected.

The silicon substrate 1 may be single crystal or polycrystalline, and a size thereof is not limited. A thickness of the silicon substrate 1 may be in a range of 10 to 20 µm. The light receiving surface of the silicon substrate 1 may be in a planar or textured structure or have another geometric light trapping structure, which is not specifically limited in this embodiment of this application.

Optionally, a material of the front selective contact layer 311 is selected from at least one of doped amorphous silicon, doped polysilicon, aluminum-doped zinc oxide, indium tin oxide, zinc oxide, tin oxide, nickel oxide, titanium nitride, or molybdenum oxide. The front selective contact layer 311 of the foregoing material has a better effect for selection and transmission for majority carriers. In addition, in a case that the material of the front selective contact layer 311 is selected from at least one of zinc oxide, tin oxide, nickel oxide, titanium nitride, or molybdenum oxide, the front selective contact layer 311 can further weaken intrinsic absorption of the light receiving surface of the silicon substrate 1 caused by a narrow bandgap of the material and parasitic absorption of the light receiving surface of the silicon substrate 1 caused by free carriers.

As shown in FIG. 1 and FIG. 3, the solar cell may further include a front anti-reflection layer 312, a front electrode 32, a back functional layer 41, and a back electrode 42. The back functional layer 41 may include a back passivation layer 410, a back selective contact layer 411, and a back anti-reflection layer 412.

A material of the front anti-reflection layer 312 may be selected from at least one of silicon nitride, silicon oxide, silicon oxynitride, aluminum nitride, titanium nitride, aluminum oxide, or titanium oxide. The front anti-reflection layer 312 may be a single-layer structure or a multi-layer structure.

The front electrode 32 is made of a metal material, which may include one or more types of metals such as gold, silver, copper, aluminum, nickel, indium, and gallium. The front electrode 32 may penetrate or partially penetrate the front anti-reflection layer 312 and directly come into contact with the front selective contact layer 311.

The back functional layer 41 may be a structure including one or more layers of passivation, carrier selective contact and transmission, anti-reflection, or the like. A material of the back anti-reflection layer 412 may be selected from at least one of silicon nitride, silicon oxide, silicon oxynitride, aluminum nitride, titanium nitride, aluminum oxide, or titanium oxide. The back anti-reflection layer 412 may be a single-layer structure or a multi-layer structure. Preferably, the back anti-reflection layer 412 has a field passivation or chemical passivation function. The back selective contact layer 411 mainly selects and conducts majority carriers of a back surface of the silicon substrate 1, where a transmission direction of carriers is not limited. The back passivation layer 410 mainly passivates the back surface of the silicon substrate 1. A material of the back passivation layer 410 may be selected from at least one of silicon oxide or intrinsic amorphous silicon. A thickness of the back passivation layer 410 is not limited. Materials of the back selective contact layer 411 and the back passivation layer 410 may respectively be: intrinsic amorphous silicon and doped amorphous silicon, silicon oxide and doped polysilicon, silicon oxide and zinc oxide, or the like.

The back electrode 42 is made of a metal material, which may include one or more types of metals such as gold, silver, copper, aluminum, nickel, indium, and gallium. The back electrode 42 may penetrate or partially penetrate the back functional layer 41.

An embodiment of this application further provides a photovoltaic module, including the solar cell according to any one of the foregoing. The photovoltaic module has beneficial effects the same as or similar to those of the foregoing solar cell. Mutual reference may be made for relevant parts. To avoid repetition, details are not described herein again.

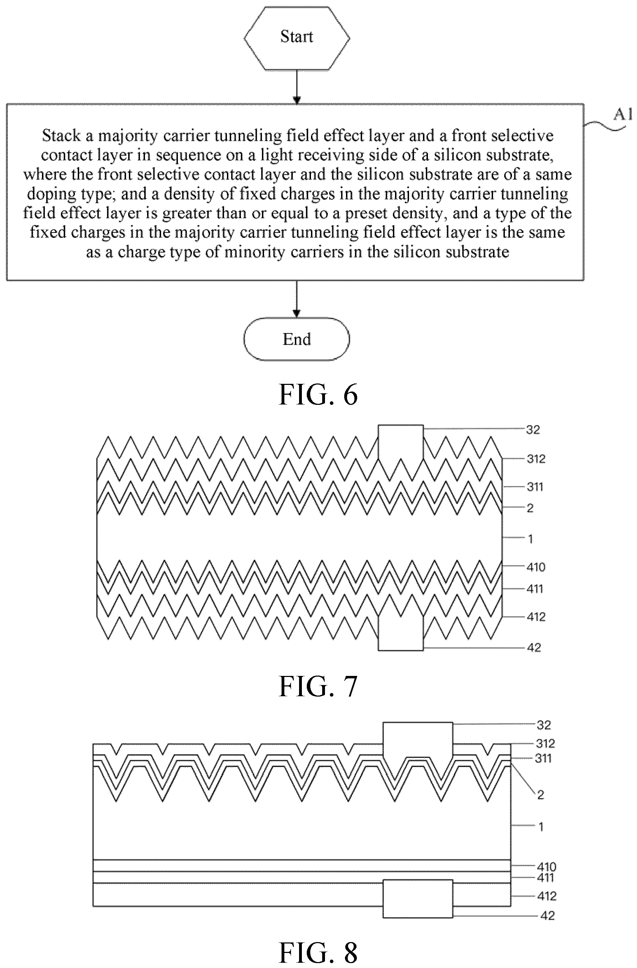

FIG. 6 is a flowchart of steps of a production method for the solar cell according to any one of the foregoing in an embodiment of this application. Referring to FIG. 6, the method includes the following steps:
Step A1: Stack a majority carrier tunneling field effect layer and a front selective contact layer in sequence on a light receiving side of a silicon substrate, where the front selective contact layer and the silicon substrate are of a same doping type; and a density of fixed charges in the majority carrier tunneling field effect layer is greater than or equal to a preset density, and a type of the fixed charges in the majority carrier tunneling field effect layer is the same as a charge type of minority carriers in the silicon substrate.

The production method for the solar cell has beneficial effects the same as or similar to those of the foregoing solar cell. Mutual reference may be made for relevant parts. To avoid repetition, details are not described herein again.

Optionally, a material of the majority carrier tunneling field effect layer 2 is selected from a dielectric material. The method further includes: performing injection on the majority carrier tunneling field effect layer 2, to cause a charge type on a surface of the majority carrier tunneling field effect layer 2 close to the silicon substrate 1 after the injection to be the same as the type of the fixed charges. The injection increases the fixed charges in the majority carrier tunneling field effect layer 2, to enhance the effect of repelling the non-equilibrium minority carriers of the light receiving surface of the silicon substrate 1.

A principle according to which the injection increases the fixed charges in the majority carrier tunneling field effect layer 2 is that: Some of the fixed charges in the majority carrier tunneling field effect layer 2 originate from electrons or holes in the silicon substrate 1, and are bound by defects in the majority carrier tunneling field effect layer 2, thereby being fixed into the majority carrier tunneling field effect layer 2 and implements a field effect. Through the injection, charges in the silicon substrate 1 can be promoted to migrate, to improve a probability that the charges enter the majority carrier tunneling field effect layer 2 and are bound and fixed, thereby increasing the density of the fixed charges.

It should be noted that the injection herein may be performed in a case that the density of the fixed charges in the majority carrier tunneling field effect layer 2 is less than the preset charge density, to cause the density of the fixed charges in the majority carrier tunneling field effect layer 2 to reach the preset charge density. The injection herein may also be performed in a case that the density of the fixed charges in the majority carrier tunneling field effect layer 2 reaches the preset charge density, to cause the density of the fixed charges in the majority carrier tunneling field effect layer 2 to be greater than the preset charge density. This is not specifically limited in this embodiment of this application. For example, the injection herein may be performed in a case that the density of the fixed charges in the majority carrier tunneling field effect layer 2 is less than the preset charge density, to cause the density of the fixed charges in the majority carrier tunneling field effect layer 2 reaches the preset charge density. After the density of the fixed charges in the majority carrier tunneling field effect layer 2 reaches the preset charge density, the injection is continued, to increase the density of the fixed charges in the majority carrier tunneling field effect layer 2.

Optionally, the injection includes at least one of electrical injection, optical injection, or hot injection. The injection is performed in various manners.

Optionally, a voltage of the electrical injection is less than a breakdown voltage of the solar cell, which can prevent the solar cell from being broken down.

Optionally, the optical injection can be performed through irradiation with ultraviolet light. A wavelength of the ultraviolet light is less than or equal to 300 nm.

Optionally, a temperature of the hot injection is greater than or equal to 600°C.

Optionally, the majority carrier tunneling field effect layer 2 is arranged through a deposition process. For example, the majority carrier tunneling field effect layer 2 may be arranged in a manner such as atomic layer deposition (ALD), molecular beam epitaxy (MBE), or metal organic chemical vapor deposition (MOCVD).

This application is further explained below with reference to specific embodiments.

### Embodiment 1

FIG. 7 is a schematic structural diagram of a fifth type of solar cell according to an embodiment of this application. Referring to FIG. 7, FIG. 7 is a schematic structural diagram of a heterojunction solar cell.

A silicon substrate 1 is an N-type silicon substrate. In a case that a doping concentration of the silicon substrate 1 is in a range of 10¹⁰/cm² to 10¹⁶/cm², a thickness of the silicon substrate 1 may be in a range of 30 to 150 µm. Preferably, the doping concentration of the silicon substrate 1 may be negatively correlated with the thickness of the silicon substrate 1. For example, in a case that the doping concentration of the silicon substrate 1 is in a range of 10¹⁰/cm² to 10¹⁴/cm², the thickness of the silicon substrate 1 is in a range of 80 to 150 µm. In a case that the doping concentration of the silicon substrate 1 is greater than 10¹⁴/cm² and less than or equal to 10¹⁶/cm², the thickness of the silicon substrate 1 is greater than or equal to 30 µm and less than 80 µm. Both a light receiving surface and a back surface of the silicon substrate 1 have a textured light trapping structure.

A transition metal oxide with positive fixed charges, specifically, hafnium oxide, is used as a material of a majority carrier tunneling field effect layer 2. The majority carrier tunneling field effect layer 2 has a thickness of 1 nm and is deposited through a ALD method. An interface between the majority carrier tunneling field effect layer 2 and the silicon substrate 1 has a chemical passivation interface layer with a thickness of about 0.5 nm. The chemical passivation interface layer may be a silicon oxide interface layer. In addition, the material of the majority carrier tunneling field effect layer 2 may also include hafnium silicon oxide, yttrium oxide, a lanthanide metal oxide such as lanthanum oxide, or a mixture or a stacked structure of the foregoing materials.

A front selective contact layer 311 is arranged on the light receiving surface of the majority carrier tunneling field effect layer 2, and the front selective contact layer 311 may include N-type amorphous silicon (or carbon-containing amorphous silicon, or amorphous silicon carbide) and a transparent conductive film. The N-type amorphous silicon (or carbon-containing amorphous silicon, or amorphous silicon carbide) may be deposited through PECVD. The transparent conductive film is made of indium tin oxide, and is deposited through magnetron sputtering. In addition, the transparent conductive film may also be made of indium gallium oxide, aluminum-doped zinc oxide, gallium-doped zinc oxide, or the like.

A front anti-reflection layer 312 is arranged on a light receiving surface of the front selective contact layer 311, and may be made of a silicon nitride film or an aluminum oxide or silicon nitride multi-layer anti-reflection film, or one or more layers of other optical film materials with a refractive index in a range of 1.5 to 3.5.

A front electrode 32 is arranged on a light receiving surface of the front anti-reflection layer 312. The front electrode 32 penetrates the front anti-reflection layer 312 and comes into direct contact with the front selective contact layer 311 to achieve an electrical connection. The front electrode 32 is made of a metal material, preferably, a material such as silver, copper, nickel, zinc, or aluminum, or a mixed material or a stacked structure including two or more of the foregoing metals.

A back passivation layer 410 is arranged on the back surface of the silicon substrate 1, is made of intrinsic amorphous silicon, has a thickness of 3 to 5 nm, and is obtained through a PECVD deposition process.

A back selective contact layer 411 is arranged on a back surface of the back passivation layer 410, and the back selective contact layer 411 may include P-type amorphous silicon (or carbon-containing amorphous silicon, or amorphous silicon carbide) and a transparent conductive film. The P-type amorphous silicon (or carbon-containing amorphous silicon, or amorphous silicon carbide) is deposited through PECVD. The transparent conductive film is made of indium tin oxide, and is deposited through magnetron sputtering. In addition, the transparent conductive film may also be made of indium gallium oxide, aluminum-doped zinc oxide, gallium-doped zinc oxide, or the like.

A back anti-reflection layer 412 is arranged on a back surface of the back selective contact layer 411, and may be made of a silicon nitride film or an aluminum oxide or silicon nitride multi-layer anti-reflection film, or one or more layers of other optical film materials with a refractive index in a range of 1.5 to 3.5.

A back electrode 42 is arranged on a back surface of the back anti-reflection layer 412. The back electrode 42 penetrates the back anti-reflection layer 412 and comes into direct contact with the back selective contact layer 411 to achieve an electrical connection. The back electrode 42 is made of a metal material, preferably, a material such as silver, copper, nickel, zinc, or aluminum, or a mixed material or a stacked structure including two or more of the foregoing metals.

Moreover, the silicon substrate 1 in Embodiment 1 may also be made of a P-type silicon wafer. Limitations other than a doping type are consistent with those in the foregoing solution. In addition, types of carriers in the front selective contact layer 311 and the back selective contact layer 411 are opposite to those in the foregoing solution. In addition, the majority carrier tunneling field effect layer 2 is made of a transition metal oxide with negative fixed charges, specifically, tantalum oxide, titanium oxide, strontium titanium oxide, zirconium oxide, or a mixture or a stacked structure of the foregoing materials.

### Embodiment 2

FIG. 8 is a schematic structural diagram of a sixth type of solar cell according to an embodiment of this application. Referring to FIG. 8, FIG. 8 is a schematic structural diagram of a polysilicon passivated contact solar cell.

A silicon substrate 1 is an N-type silicon substrate, a thickness thereof is not limited, and a doping concentration thereof is not limited. Alight receiving surface of the silicon substrate 1 has an inverted-pyramid textured light trapping structure, and a back surface of the silicon substrate 1 has a diffused P-N junction. In a case that the doping concentration of the silicon substrate 1 is in a range of 10¹⁰/cm² to 10¹⁸/cm², the thickness of the silicon substrate 1 may be in a range of 20 to 200 µm. Preferably, the doping concentration of the silicon substrate 1 may be negatively correlated with the thickness of the silicon substrate 1. For example, in a case that the doping concentration of the silicon substrate 1 is in a range of 10¹⁰/cm² to 10¹⁵/cm², the thickness of the silicon substrate 1 is in a range of 50 to 200 µm. In a case that the doping concentration of the silicon substrate 1 is greater than 10¹⁵/cm² and less than or equal to 10¹⁸/cm², the thickness of the silicon substrate 1 is greater than or equal to 20 µm and less than 50 µm. A doping concentration of a P-type region diffused on the back surface of the silicon substrate 1 is not limited.

A transition metal oxide with positive fixed charges, specifically, hafnium oxide, is used as a material of a majority carrier tunneling field effect layer 2. The majority carrier tunneling field effect layer 2 has a thickness of 1.0 nm and is deposited through a ALD method by using an oxygen-containing metal compound source rather than an independent oxygen source (the independent oxygen source may be oxygen, ozone, water vapor, or the like). There is only a silicon-oxygen bond layer at an interface between the majority carrier tunneling field effect layer 2 and the silicon substrate 1. In addition, the material of the majority carrier tunneling field effect layer 2 may also include hafnium silicon oxide, yttrium oxide, a lanthanide metal oxide such as lanthanum oxide, or a mixture or a stacked structure of the foregoing materials.

A front selective contact layer 311 is arranged on a light receiving surface of the majority carrier tunneling field effect layer 2 and is made of N-type polysilicon. The front selective contact layer 311 has a thickness of 5 to 8 nm and a doping concentration higher than that of the silicon substrate 1. The doping concentration of the front selective contact layer 311 may be in a range of 10¹⁵/cm² to 10²⁰/cm². A process of first depositing N-type amorphous silicon and then performing high-temperature crystallization is adopted for the front selective contact layer 311.

A front anti-reflection layer 312 is arranged on a light receiving surface of the front selective contact layer 311, and may be made of a crystalline silicon nitride film or an aluminum oxide or silicon nitride multi-layer anti-reflection film, or one or more layers of other optical film materials with a refractive index in a range of 1.5 to 3.5.

A front electrode 32 is arranged on a light receiving surface of the front anti-reflection layer 312. The front electrode 32 penetrates the front anti-reflection layer 312 and comes into direct contact with the front selective contact layer 311 to achieve an electrical connection. The front electrode 32 is made of a metal material, preferably, a material such as silver, copper, nickel, zinc, or aluminum, or a mixed material or a stacked structure including two or more of the foregoing metals.

A back passivation layer 410 is arranged on a back surface of the silicon substrate 1. The back passivation layer 410 is made of tunneling silicon oxide through a hot oxygen process.

A back selective contact layer 411 is arranged on a back surface of the back passivation layer 410. The back selective contact layer 411 is made of P-type polysilicon, and has a thickness of 5 to 20 nm and a doping concentration not lower than a peak doping concentration of a P-type region on the back surface of the silicon substrate 1. A process of first depositing P-type amorphous silicon and then performing high-temperature crystallization is adopted for the back selective contact layer 411.

A back anti-reflection layer 412 is arranged on a back surface of the back selective contact layer 411, and may be made of a silicon nitride film or an aluminum oxide or silicon nitride multi-layer anti-reflection film, or one or more layers of other optical film materials with a refractive index in a range of 1.5 to 3.5.

A back electrode 42 is arranged on a back surface of the back anti-reflection layer 412. The back electrode 42 penetrates the back anti-reflection layer 412 and comes into direct contact with the back selective contact layer 411 to achieve an electrical connection. The back electrode 42 is made of a metal material, preferably, a material such as silver, copper, nickel, zinc, or aluminum, or a mixed material or a stacked structure including two or more of the foregoing metals.

Moreover, the silicon substrate 1 in Embodiment 2 may also be made of a P-type silicon wafer. Limitations other than a doping type are consistent with those in the foregoing Embodiment 2. In addition, types of carriers in the front selective contact layer 311 and the back selective contact layer 411 are opposite to those in the foregoing Embodiment 2. In addition, the majority carrier tunneling field effect layer 2 is made of a transition metal oxide with negative fixed charges, specifically, tantalum oxide, titanium oxide, strontium titanium oxide, zirconium oxide, or a mixture or a stacked structure of the foregoing materials.

### Embodiment 3

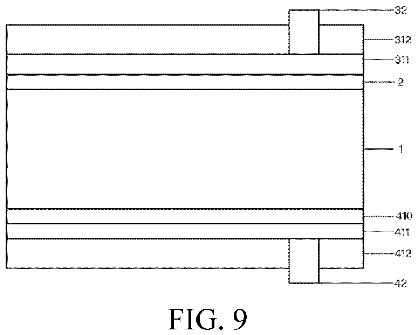

FIG. 9 is a schematic structural diagram of a seventh type of solar cell according to an embodiment of this application. Referring to FIG. 9, FIG. 9 is a schematic structural diagram of a wide-bandgap passivated contact solar cell.

A silicon substrate 1 is a P-type silicon wafer, a thickness thereof is not limited, and a doping concentration thereof is not limited. A light receiving surface of the silicon substrate 1 has a pyramid or inverted-pyramid textured light trapping structure, a nano light trapping structure, or any other light trapping structure, or a planar structure. The doping concentration of the silicon substrate 1 may be in a range of 10¹⁰/cm² to 10¹⁸/cm². The thickness of the silicon substrate 1 may be in a range of 20 to 200 µm. Preferably, the doping concentration of the silicon substrate 1 may be negatively correlated with the thickness of the silicon substrate 1. For example, in a case that the doping concentration of the silicon substrate 1 is in a range of 10¹⁰/cm² to 10¹⁵/cm², the thickness of the silicon substrate 1 is in a range of 50 to 200 µm. In a case that the doping concentration of the silicon substrate 1 is greater than 10¹⁵/cm² and less than or equal to 10¹⁸/cm², the thickness of the silicon substrate 1 is greater than or equal to 20 µm and less than 50 µm.

A transition metal oxide with negative fixed charges, specifically, titanium oxide, is used as a material of a majority carrier tunneling field effect layer 2. The majority carrier tunneling field effect layer 2 has a thickness of 1.0 nm and is deposited through a ALD method by using an oxygen-containing metal compound source rather than an independent oxygen source (the independent oxygen source may be oxygen, ozone, water vapor, or the like). There is only a silicon-oxygen bond layer at an interface between the majority carrier tunneling field effect layer 2 and the silicon substrate 1. In addition, the material of the majority carrier tunneling field effect layer 2 may also include strontium titanium oxide, or a mixture or a stacked structure of the foregoing materials.

A front selective contact layer 311 is arranged on a light receiving surface of the majority carrier tunneling field effect layer 2 and is made from a stack of tin oxide and indium-doped tin oxide. A thickness of the tin oxide is in a range of 5 to 10 nm, and a thickness of the indium-doped tin oxide is in a range of 20 to 50 nm. A sputtering deposition process is adopted from the front selective contact layer 311. Hydrogen gas is added to a carrier gas during the deposition, or annealing is performed in a hydrogen atmosphere after the deposition.

A front anti-reflection layer 312 is arranged on a light receiving surface of the front selective contact layer 311, and may be made of a silicon nitride film or an aluminum oxide or silicon nitride multi-layer anti-reflection film, or one or more layers of other optical film materials with a refractive index in a range of 1.5 to 3.5.

A front electrode 32 is arranged on a light receiving surface of the front anti-reflection layer 312. The front electrode 32 penetrates the front anti-reflection layer 312 and comes into direct contact with the front selective contact layer 311 to achieve an electrical connection. The front electrode 32 is made of a metal material, preferably, a material such as silver, copper, nickel, zinc, or aluminum, or a mixed material or a stacked structure including two or more of the foregoing metals.

A back passivation layer 410 is arranged on a back surface of the silicon substrate 1. The back passivation layer 410 is made of tunneling silicon oxide through a hot oxygen process.

A back selective contact layer 411 is arranged on a back surface of the back passivation layer 410, and is made of a stack of molybdenum oxide and aluminum-doped zinc oxide. A thickness of the molybdenum oxide is in a range of 5 to 20 nm, and a thickness of the aluminum-doped zinc oxide is in a range of 30 to 80 nm. A process of sputtering and then annealing in a hydrogen atmosphere is adopted for the back selective contact layer 411.

A back anti-reflection layer 412 is arranged on a back surface of the back selective contact layer 411. The back anti-reflection layer 412 may be made of a silicon nitride film or an aluminum oxide or silicon nitride multi-layer anti-reflection film, or one or more layers of other optical film materials with a refractive index in a range of 1.5 to 3.5.

A back electrode 42 is arranged on a back surface of the back anti-reflection layer 412. The back electrode 42 penetrates the back anti-reflection layer 412 and comes into direct contact with the back selective contact layer 411 to achieve an electrical connection. The back electrode 42 is made of a metal material, preferably, a material such as silver, copper, nickel, zinc, or aluminum, or a mixed material or a stacked structure including two or more of the foregoing metals.

It should be noted that mutual reference may be made between the solar cell, the photovoltaic module, and the production method for the solar cell, and the solar cell, the photovoltaic module and the production method for the solar cell can achieve the same or similar beneficial effects. To avoid repetition, details of relevant parts are not described again.

It should be noted that for ease of description, the method embodiments are all described as a series of action combinations. However, a person skilled in the art should learn that the embodiments of this application are not limited to the described order of the actions because some steps may be performed in another order or performed at the same time according to the embodiments of this application. In addition, a person skilled in the art should also learn that the embodiments described in the specification are all preferred embodiments, and the actions involved are not all necessarily required by the embodiments of this application.

It should be noted that terms "include", "comprise", and any variants thereof are intended to cover a non-exclusive inclusion. Therefore, in the context of a process, method, object, or apparatus that includes a series of elements, the process, method, object, or apparatus not only includes such elements, but also includes other elements not specified expressly, or may include inherent elements of the process, method, object, or device. Without more limitations, elements defined by a sentence "including one" does not exclude that there are still other same elements in the process, method, object, or apparatus.

Through the descriptions of the foregoing implementations, a person skilled in the art may clearly understand that the method according to the foregoing embodiments may be implemented through software and a necessary general hardware platform, and certainly, may also be implemented by hardware, but in many cases, the former manner is a better implementation. Based on such an understanding, the technical solutions of this application essentially, or the part contributing to the related art, may be presented in the form of a software product. The computer software product is stored in a storage medium (for example, a ROM/RAM, a magnetic disk, or an optical disc) including several instructions to enable a terminal (which may be a mobile phone, a computer, a server, an air conditioner, a network device, or the like) to perform the methods described in the embodiments of this application.

The foregoing described device embodiments are merely examples. The units described as separate parts may or may not be physically separate, and the parts displayed as units may or may not be physical units, may be located in one position, or may be distributed on a plurality of network units. Some or all the modules may be selected according to actual needs to achieve the objectives of the solutions of embodiments. A person of ordinary skill in the art may understand and implement the embodiments of this application without creative efforts.

"An embodiment", "embodiment", or "more or more embodiments" mentioned in the specification means that particular features, structures, or characteristics described with reference to the embodiment or embodiments may be included in at least one embodiment of this application. In addition, it should be noted that the wording example "in an embodiment" herein does not necessarily indicate a same embodiment.

In the specification provided herein, many specific details are provided. However, it should be understood that the embodiments of this application may be practiced without such specific details. In some examples, well-known methods, structures, and technologies are not shown in detail so as not to obscure the understanding of the specification.

Finally, it should be noted that the foregoing embodiments are merely used for describing the technical solutions of this application, but are not intended to limit this application It should be understood by a person of ordinary skill in the art that although this application has been described in detail with reference to the foregoing embodiments, modifications can be made to the technical solutions described in the foregoing embodiments, or equivalent replacements can be made to some technical features in the technical solutions, as long as such modifications or replacements do not cause the essence of corresponding technical solutions to depart from the scope of the technical solutions of the embodiments of this application.

## Claims

1. A solar cell, comprising:
a silicon substrate (1), and a majority carrier tunneling field effect layer (2) and a front selective contact layer (311) stacked in sequence on a light receiving side of the silicon substrate (1), wherein the front selective contact layer (311) and the silicon substrate (1) are of a same doping type; and
a density of fixed charges in the majority carrier tunneling field effect layer (2) is greater than or equal to a preset density, and a type of the fixed charges in the majority carrier tunneling field effect layer (2) is the same as a charge type of minority carriers in the silicon substrate (1).

2. The solar cell according to claim 1, wherein the preset density is greater than or equal to 10¹⁰/cm².

3. The solar cell according to claim 2, wherein the preset density is greater than or equal to 10¹¹/cm².

4. The solar cell according to claim 2 or 3, wherein a material of the majority carrier tunneling field effect layer (2) is selected from a dielectric material with a dielectric constant greater than or equal to 8.

5. The solar cell according to claim 1, wherein pinholes are provided in the majority carrier tunneling field effect layer (2), and the pinholes are filled with a material corresponding to the front selective contact layer (311).

6. The solar cell according to claim 5, wherein an average pore diameter of the pinholes is less than or equal to 100 nm, and a density of the pinholes is less than or equal to 10⁹/cm².

7. The solar cell according to claim 4, wherein the dielectric material comprises a transition metal oxide.

8. The solar cell according to claim 7, wherein in a case that the silicon substrate (1) is a P-type silicon substrate, the dielectric material comprises at least one of tantalum oxide, titanium oxide, strontium titanium oxide, or zirconium oxide; and
in a case that the silicon substrate (1) is an N-type silicon substrate, the dielectric material comprises at least one of hafnium oxide, hafnium silicon oxide, yttrium oxide, or a lanthanide metal oxide.

9. The solar cell according to claim 4, wherein the material of the majority carrier tunneling field effect layer (2) further comprises hydrogen.

10. The solar cell according to any one of claims 1 to 9, wherein the silicon substrate (1) and the majority carrier tunneling field effect layer (2) are arranged immediately adjacent to each other; or
the solar cell further comprises a chemical passivation interface layer located between the silicon substrate (1) and the majority carrier tunneling field effect layer (2), a thickness of the chemical passivation interface layer is less than or equal to 1 nm, and a direction of the thickness of the chemical passivation interface layer is perpendicular to a light receiving surface of the silicon substrate (1).

11. The solar cell according to claim 10, wherein the chemical passivation interface layer is located on a surface of the silicon substrate (1), the chemical passivation interface layer is a silicon-oxygen bond layer, and the thickness of the chemical passivation interface layer is less than or equal to 0.5 nm.

12. The solar cell according to any one of claims 1 to 9, wherein the majority carrier tunneling field effect layer (2) is a single-layer structure or a multi-layer structure; and/or
a thickness of the majority carrier tunneling field effect layer (2) is in a range of 0.5 to 5 nm, and a direction of the thickness of the majority carrier tunneling field effect layer (2) is perpendicular to a light receiving surface of the silicon substrate (1).

13. The solar cell according to claim 12, wherein the thickness of the majority carrier tunneling field effect layer (2) is in a range of 0.5 to 2 nm.

14. The solar cell according to any one of claims 1 to 9, wherein an area of a projection of the front selective contact layer (311) on a light receiving surface of the silicon substrate (1) is less than or equal to an area of the light receiving surface of the silicon substrate (1); and/or
an area of a projection of the majority carrier tunneling field effect layer (2) on the light receiving surface of the silicon substrate (1) is less than or equal to the area of the light receiving surface of the silicon substrate (1).

15. The solar cell according to any one of claims 1 to 9, wherein an area of a projection of the majority carrier tunneling field effect layer (2) on a light receiving surface of the silicon substrate (1) is greater than or equal to an area of a projection of the front selective contact layer (311) on the light receiving surface of the silicon substrate (1); and the projection of the front selective contact layer (311) on the light receiving surface of the silicon substrate (1) entirely falls within the projection of the majority carrier tunneling field effect layer (2) on the light receiving surface of the silicon substrate (1).

16. The solar cell according to any one of claims 1 to 9, wherein
the front selective contact layer (311) is a single-layer structure or a multi-layer structure; and/or
a bandgap of a material of the front selective contact layer (311) is greater than or equal to a preset bandgap; and/or
a doping concentration of the silicon substrate (1) is negatively correlated with a thickness of the silicon substrate (1), and a direction of the thickness of the silicon substrate (1) is perpendicular to a light receiving surface of the silicon substrate (1); and/or
the solar cell is one of a heterojunction solar cell, a polysilicon passivated contact solar cell, or a wide-bandgap passivated contact solar cell; and/or
the silicon substrate (1) has a front junction structure or a back junction structure.

17. The solar cell according to claim 16, wherein
a material of the front selective contact layer (311) is selected from at least one of doped amorphous silicon, doped polysilicon, aluminum-doped zinc oxide, indium tin oxide, zinc oxide, tin oxide, nickel oxide, titanium nitride, or molybdenum oxide.

18. A photovoltaic module, comprising a plurality of solar cells according to any one of claims 1 to 17.

19. A production method for the solar cell according to any one of claims 1 to 17, comprising:
stacking a majority carrier tunneling field effect layer (2) and a front selective contact layer (311) in sequence on a light receiving side of a silicon substrate (1), wherein the front selective contact layer (311) and the silicon substrate (1) are of a same doping type; and a density of fixed charges in the majority carrier tunneling field effect layer (2) is greater than or equal to a preset density, and a type of the fixed charges in the majority carrier tunneling field effect layer (2) is the same as a charge type of minority carriers in the silicon substrate (1).

20. The production method for the solar cell according to claim 19, wherein a material of the majority carrier tunneling field effect layer (2) is selected from a dielectric material, and the method further comprises:
performing injection on the majority carrier tunneling field effect layer (2), to cause a charge type on a surface of the majority carrier tunneling field effect layer (2) close to the silicon substrate (1) after the injection to be the same as the type of the fixed charges.

21. The production method for the solar cell according to claim 20, wherein the injection comprises at least one of electrical injection, optical injection, or hot injection.

22. The production method for the solar cell according to claim 21, wherein a voltage of the electrical injection is less than a breakdown voltage of the solar cell;
the optical injection is performed through irradiation with ultraviolet light, wherein a wavelength of the ultraviolet light is less than or equal to 300 nm; and
a temperature of the hot injection is greater than or equal to 600°C.

23. The production method for the solar cell according to any one of claims 19 to 22, wherein the majority carrier tunneling field effect layer (2) is arranged through a deposition process.
